# EUROPEAN PATENT APPLICATION

(11) **EP 4 474 521 A1**
(43) Date of publication of application: **11.12.2024**
(21) Application number: 23177919.0
(22) Date of filing: 07.06.2023
(51) Int. Cl.: C23C 14/00, C23C 14/02, C23C 14/04, C23C 14/16, C23C 14/34, H01J 37/34, F41A 21/00

(54) **METHOD FOR COATING FIREARM BARREL**

(71) Applicant: FN Herstal S.A., 4040 Herstal (BE)
(72) Inventor: AUSSAVY, Delphine, 4600 Visé (BE); STUTO, Giorlando, 4100 Seraing (BE); FERON, Geoffroy, 4351 Hodeige (BE); DUBOIS, Michaël, 1040 Etterbeek (BE)
(74) Representative: AWA Benelux

(57) **Abstract**

The present invention relates to a method for providing a coating on the internal surface of a barrel of a small calibre or medium calibre firearm, the internal surface defining an internal volume, the method comprising: providing, in a reaction chamber, a firearm comprising a barrel to be treated and a cylindrical electrode having an outer surface and comprising a target material substantially coaxially within the barrel; closing the reaction chamber; reducing the pressure to a predetermined pressure value, supplying a gas to the reaction chamber, thereby providing the gas in the internal volume and increasing the pressure within the reaction chamber to a working pressure; applying a first electric field to the electrode, so as to use the electrode as a target cathode and the barrel as an anode, thereby activating the gas into a plasma gas; removing the target material by the plasma gas and depositing it on the internal surface; turning off the first electric field; stopping the supply of the gas; bringing the reaction chamber back to atmospheric pressure; removing the firearm comprising the treated barrel from the reaction chamber; the distance between the outer surface of the electrode and the internal surface of the barrel being at least 0.5 mm, the electric field being applied for a duration sufficiently long to form a layer of target material on the internal surface of the barrel, and the product of the working pressure and the distance between the electrode and the internal surface being between 10⁻⁵ Torr.cm and 45 Torr.cm.

## Description

### Technical field

The present invention is related a method for coating a barrel of a firearm, in particular for coating the internal surface of the barrel. The method is in particular suited for barrels of small calibre and medium calibre firearms.

### Background art

It is known that firearms, and in particular the barrel(s) thereof, are, in use, exposed to extreme conditions in terms of temperature, mechanical stress and chemical exposure. In order to extend the lifetime of the firearms, it is therefore known to provide a coating on the internal surface of the firearm components exposed to such extreme conditions.

US 9,546,837 discloses a gun barrel having a coating on its internal surface. The coating provides improved the fatigue, thermal resistance, corrosion resistance, erosion resistance, crack resistance and/or wear resistance as compared to uncoated gun barrels. The coating comprises a first metallic component, which is tantalum, niobium, zirconium, rhenium, hafnium, or tungsten, as well as molybdenum and optionally tin. The coating can comprise different layers or regions and its properties may vary along the thickness of the coating. The coating can be deposited by means of physical vapour deposition methods, such as sputtering methods.

However, it has been found that coating compositions comprising chromium are preferred because they offer the best performance in terms of temperature resistance, resistance against mechanical stress and resistance against harsh chemicals. Hexavalent chromium is particularly preferred because the use of chrome plating inducing the formation of chromium in the trivalent form is forbidden by the European legislation (REACH) since 2017.

Various techniques have been developed for coating surfaces with different materials, including hexavalent chromium. One commonly used method for coating components is Physical Vapor Deposition (PVD), which involves depositing thin films of materials onto various surfaces. PVD processes, such as sputtering, cathodic arc evaporation, thermal evaporation, or electron beam evaporation, are often carried out in vacuum chambers where the article to be coated is exposed to a coating source. However, applying PVD coatings to the internal surfaces of barrels, in particular of small and medium caliber firearms, can be difficult as these processes are line-of-sight-based and are not capable of depositing coatings inside deep cavities.

To overcome this limitation, several methods have been developed over time to deposit a coating on the internal surface of gun barrels, cannon barrels and firearm barrels.

US2004005296 discloses a method for applying a coating on the internal surface of a gun barrel, comprising passing a plasma jet spraying device through the barrel to apply a coating composition, followed by exposure to UV light to harden the coating composition, thereby obtaining a hard coating.

A disadvantage of the foregoing methods is that they are unsuited for coating the inside of barrels of small and medium calibre firearms. The barrels of small and medium firearms typically have an inner diameter between 4 mm and 4 cm, which is too small to accommodate spraying devices and other devices, such as UV light sources, in a way allowing for the homogeneous deposition of a coating of uniform thickness and with the required properties.

US 8,110,043 describes an apparatus and method for applying coatings to the interior surfaces of components, such as gun barrels, using a vacuum chamber and an evaporant source. The primary carrier gas streams deflect the evaporated vapor flux from an area distal from and external to the substrate into the interior cavity, coating at least a portion of the interior of the longitudinal section of the substrate. The method involves the use of an energetic beam and primary carrier gas streams to direct the vapor flux towards the interior surfaces for coating.

A disadvantage of the foregoing method and apparatus is that the evaporant source is located away from the interior of the gun barrel, and that a carrier gas is required to transport the evaporated vapour flux to and provide it in the internal volume of the barrel. Consequently, the deposited coating will be rather non-uniform and non-homogeneous.

WO2022/261684 discloses an apparatus and a method for forming a coating on the inner surface of a hollow article, such as a barrel. The apparatus comprises a plasma source with an elongate shape, which comprises a hollow cathode and a hollow target material, which are connected to one another in an electrically conductive manner. The hollow cathode and the target material can be made of the same material. The apparatus also has a masking element that partially covers the outer surface of the cathode and the target to prevent plasma formation in the masked area during operation. The target has a plasma formation area that is not covered by the masking element.

A disadvantage of the foregoing apparatus and method is that hollow cathodes of excellent quality and geometry are known to be more difficult to produce, and can thus be more expensive than for example solid (i.e. not-hollow) cathodes. A further disadvantage is that the masking reduces the area where a plasma is formed, and where a coating is deposited on the internal surface of the hollow article. This leads to a slower deposition process, i.e. longer processing times, and may also lead to a reduction of the uniformity and homogeneity of the deposited coating. A masking is also an additional component, which renders the apparatus more expensive.

### Summary of the invention

The present invention aims to overcome one or more of the above drawbacks. It is an aim of the invention to provide a method to homogeneously deposit a coating on the internal surface of a barrel of small and medium calibre firearms. It is a further aim to provide a method for depositing a coating which is uniform in thickness. It is also an aim to provide a method for depositing a coating as a speed which is industrially applicable, allowing scaling up the method from lab scale to industrial scale.

It is a further aim to provide methods to increase the lifetime of the barrel. It is also an aim to provide methods to deposit coatings showing excellent adhesion to the internal surface of the barrel. In particular, it is an aim to provide methods for depositing coatings having a high mechanical strength, a high chemical resistance and a high thermal resistance. Yet a further aim is to provide methods which are less expensive than existing methods, for example by using a less complex and/or less expensive electrode.

According to a first aspect of the invention, there is provided a method for providing a coating on the internal surface of a hollow cylindrical component of a firearm. A particularly preferred example of such a hollow cylindrical component is a barrel.

In particular, the first aspect provides a method for providing a coating on the internal surface of a barrel of a firearm as set out in the appended claims.

The barrel has the form of a hollow tube or cylinder. The internal surface of the barrel defines an internal volume. The barrel is advantageously made of materials known in the art. Non-limiting examples of such materials include steel and steel based alloys.

The firearm is a small calibre firearm or a medium calibre firearm. Advantageously, the internal diameter of the barrel of the small calibre or medium calibre firearm is between 4 mm and 40 mm, preferably between 5 mm and 30 mm, such as between 5 mm and 20 mm.

The firearm comprising the barrel to be treated is provided, i.e. arranged, positioned or placed, in a reaction chamber. The barrel can be provided in a vertical position with regards to the surface of the earth, in a horizontal position, or at an inclined position at an angle between 0° and 180° relative to the surface of the earth.

A cylindrical electrode comprising a target material is provided, i.e. arranged or positioned or placed, within the internal volume of the barrel. The cylindrical electrode has an outer surface. The target material is comprised at least at the outer surface of the cylindrical electrode. In other words, at least the outer surface of the cylindrical electrode comprises the target material. Advantageously, the target material forms a continuous and uniform radial outer surface of the cylindrical electrode. This means that the cylindrical electrode used for coating has a continuous and uniform radial outer surface that is made of the same material as the target material. In other words, the entire outer surface of the cylindrical electrode is made up of the same material that is intended to be deposited onto the surface of the hollow object being coated. This helps to ensure that the coating material is evenly and uniformly deposited onto the surface of the object, resulting in a high-quality coating. Alternatively, and advantageously, the electrode consists of the target material, i.e. the entire electrode is made of target material.

Advantageously, the target material of the electrode comprises or substantially consists of a metal or a metal alloy. Preferably, the metal is chromium. Alternatively or additionally, and advantageously, the target material comprises or substantially consists of a ceramic material.

Advantageously, the outer surface of the electrode comprising the target material is exposed to the internal volume of the barrel. In other words, advantageously no covering layer, i.e. masking or masking layer, is provided at the outer surface of the electrode. The inventors have found that such a covering or masking is not required for obtaining homogeneous coatings with a uniform thickness on the internal surface of the barrel. Further, the absence of any masking was found to allow a faster deposition of the coating, while maintaining its uniformity.

The cylindrical electrode is positioned substantially parallel to the central axis of the barrel. Preferably, the electrode is positioned substantially coaxially within the internal volume of the barrel, i.e. substantially at the central axis of the barrel. With "substantially coaxially" and "substantially at the central axis of the barrel" is meant in the present disclosure that, the distance between the internal surface and (the outer surface of) the cylindrical electrode is substantially homogeneous at every position. This means that the coating is deposited consistently at the same distance from the internal surface throughout the entire internal volume of the barrel, resulting in a uniform and consistent coating thickness.

The electrode is arranged so that its outer surface is not in contact with the internal surface of the barrel. With "not in contact" is meant in the present disclosure that there is a distance or a gap larger than 0 mm between the outer surface of the electrode and the internal surface of the barrel over the entire surface area of the internal surface of the barrel.

Advantageously, the distance or the gap between the outer surface electrode and the internal surface is at least 0.5 mm, preferably at least 1.0 mm, such as at least 1.5 mm or at least 2.0 mm. Advantageously, given the inner diameter of barrels of small and medium calibre firearms, the distance is at most 19.5 mm, such as at most 19.0 mm, or at most 15.0 mm. Advantageously, the distance is between 0.5 mm and 19.5 mm, such as between 1.0 mm and 19.0 mm. It will be understood that the maximal distance possible depends on the internal diameter of the barrel.

In a preferred embodiment of the invention, the shape of the cylindrical electrode can be adapted to the internal diameter of the barrel to be treated. For insertion into the barrel, the outer diameter of the cylindrical electrode needs to be smaller than the inner diameter of the barrel to be treated.

Once the cylindrical electrode is arranged coaxially with the barrel, the reaction chamber is closed and evacuated to reduce the pressure within the chamber until a predetermined value, i.e. a base pressure, is reached. This allows to remove any contaminants from the reaction chamber, such as moisture.

Advantageously, the predetermined pressure or base pressure is between 10⁻⁷ mbar and 100 mbar, such as between 10⁻⁶ mbar and 50 mbar, preferably between 10⁻⁵ mbar and 25 mbar, more preferably between 10⁻⁵ mbar and 10 mbar, such as between 10⁻⁵ mbar and 1 mbar, between 10⁻⁵ mbar and 0.1 mbar, for example between 0.001 mbar and 0.1 mbar.

Upon reaching the predetermined pressure within the reaction chamber, a gas is supplied to, i.e. introduced in or passed through, the reaction chamber. Consequently, the gas is provided in the internal volume of the barrel comprising the cylindrical electrode.

In the light of the present invention, with "gas" it is meant a single gas or a mixture of two or more gases. Advantageously, the gas comprises or substantially consist of an inert gas selected from the group consisting of helium, neon, argon, krypton. Alternatively or additionally, and advantageously, the gas comprises or substantially consists of a reactive gas. Advantageously, the reactive gas is selected from the group consisting of nitrogen, oxygen, methane, ammonia, acetylene or a fluorocarbon.

Upon supplying or introducing the gas, the pressure increases to a working pressure. According to the invention, the term "working pressure", refers to the local, absolute pressure where the plasma is formed. The working pressure is measured near or at the target's surface. It thus represents the absolute pressure at or near the surface of the target where the plasma is formed. The working pressure relates to the equilibrium pressure that is achieved by simultaneously injecting gas and pumping in a plasma system.

A first electric field is then applied to the electrode. Consequently, the electrode acts, or is used, as a cathode comprising the target material, i.e. a target cathode. Consequently, the barrel acts, or is used, as anode. The barrel, i.e. the anode, can be grounded or biased.

Advantageously, the average power density applied to the target cathode is between 0.01 W/cm² and 50 W/cm², preferably between 0.1 W/cm² and 25 W/cm², more preferably between 1 W/cm² and 10 W/cm², for example between 2 W/cm² and 8 W/cm², or between 4 W/cm² and 6 W/cm². In the present disclosure, "average power density" is used for the average amount of power applied per unit area of the target cathode surface, wherein "average amount of power" is used for the average power that is applied during the entire duration that the first electric field is applied to the electrode.

Advantageously, the average current density applied to the target cathode is between 0.001 A/cm² and 10 A/cm², preferably between 0.0025 A/cm² and 5 A/cm², more preferably between 0.05 A/cm² and 1 A/cm², for example between 0.01 A/cm² and 0.5 A/cm², such as between 0.01 A/cm² and 0.2 A/cm². In the present disclosure, "average current density" is used for the average amount of electric current passing through the target cathode per unit area, wherein "average amount of electric current" is used for the average electric current that passes through the target cathode during the entire duration that the first electric field is applied to the electrode.

The electric field activates or discharges the gas into a plasma gas or a plasma discharge, i.e. the electric field ignites a plasma comprising the activated gas. Advantageously, AC (alternating current) as well as DC (direct current) can be used for applying the electric field. The AC power and the DC power, whichever is used, can be generated and provided by means known in the art, such as by a bipolar means or by means of radiofrequency. The choice between AC power and DC power depends on various factors, including the specific material being deposited, the desired coating properties, and the equipment setup.

Advantageously, the working pressure is chosen so that the product of the working pressure and the distance between the outer surface of the electrode and the internal surface is between 10⁻⁶ Torr.cm and 75 Torr.cm, preferably between 10⁻⁵ Torr.cm and 45 Torr.cm, such as between 10⁻⁴ Torr.cm and 40 Torr.cm, preferably between 0.001 Torr.cm and 35 Torr.cm, such as between 0.01 Torr.cm and 30 Torr.cm, more preferably between 0.01 Torr.cm and 10 Torr.cm, such as between 0.05 Torr.cm and 5 Torr.cm.

Consequently, the gas discharge takes place in the Townsend regime. This results in a homogeneous discharge of a large radius and contributes to the homogeneity and uniformity of the obtained coating.

The activated gas, i.e. the plasma gas, removes at least a portion of the target material from the target cathode. In particular, ions in the plasma gas remove the target material upon contacting the cathode. The removed target material is then deposited on the internal surface of the barrel, thereby obtaining a treated barrel. This method of deposition is also known as sputtering.

The cylindrical electrode leads to an isotropic sputtering. In other words, the target material is sputtered in a radially homogeneous way so that all areas of the internal surface are covered with the target material. This leads to a more uniform and consistent coating thickness on the internal surface of the barrel.

The electric field is applied for a duration sufficiently long to form a layer of target material on the internal surface. Advantageously, the layer of target material, i.e. the coating, has a thickness between 1 µm and 100 µm, preferably between 2 µm and 75 µm, such as between 3 µm and 50 µm, more preferably between 5 µm and 40 µm. Advantageously, the relative deviation of the thickness of the coating is at most 20%.

Advantageously, the electrode has a length equal to or higher than the length of the barrel. This allows to deposit target material, which is removed from the electrode acting as target cathode, simultaneously over the entire internal surface of the barrel. This has the advantage that the coating can be obtained in a fast and easy way.

Alternatively and also advantageously, the electrode has a length lower than the length of the barrel. In order to allow deposition of target material on the entire internal surface of the barrel, the electrode and barrel are configured to move relative to one another. Advantageously, the movement is a parallel movement. Such a parallel movement allows to maintain the coaxial positioning of the electrode within the internal volume of the barrel.

The electrode can comprise a plurality of sub-electrodes. Advantageously, the sub-electrodes are arranged in series. Advantageously, each sub-electrode comprises a target material. The target material of at least two of the plurality of sub-electrodes can be the same or can be different.

Once a coating layer of the desired thickness has been obtained on the internal surface of the barrel, the first electric field is turned off. The supply of gas, i.e. the passage of gas, is stopped, and the reaction chamber is brought back to atmospheric pressure to allow opening thereof. The small or medium calibre firearm comprising the treated barrel is the removed from the reaction chamber.

Optionally, prior to bringing the reaction chamber back to atmospheric pressure, the pressure in the reaction chamber is brought back to the predetermined pressure or base pressure once the supply of gas is stopped. This advantageously allows to remove any residual gases and any residual target material from the reaction chamber prior to opening the chamber, which reduces the risk of exposure of the operator to these components, and increases the operating safety.

The method can further comprise a pre-treatment of the internal surface of the barrel prior to deposition of the target material thereto, i.e. prior to coating the internal surface. Advantageously, the pre-treatment includes the removal of contaminants from the internal surface, such as organic contaminants.

Advantageously, the pre-treatment comprises or substantially consists of a cleaning and/or an etching step. With cleaning is meant in the light of the present disclosure the mere removal of contaminants, in particular organic contaminants. With etching is meant in the light of the present invention the removal of contaminants and the attachment of specific functional groups at the surface of the internal surface of the barrel. Such functional groups can contribute to the adhesion of the coating of target material.

Advantageously, the pre-treatment is performed prior to placing the barrel in the reaction chamber. Such a pre-treatment can include a cleaning or an etching, for example an ultrasonic cleaning or sandblasting, of the internal surface of the barrel. Preferably, the pre-treatment performed prior to placing the barrel in the reaction chamber comprises or substantially consists of sandblasting the internal surface of the barrel.

Alternatively or additionally, and also advantageously, the pre-treatment is performed in the same reaction chamber as the reaction chamber used for the coating deposition. Advantageously, when the pre-treatment is performed in the reaction chamber, it comprises or substantially consists of a plasma assisted pre-treatment. Advantageously, the plasma assisted pre-treatment is performed once the predetermined pressure or base pressure is obtained and prior to the introduction or supply of the gas for the removal of the target material from the electrode.

Advantageously, the plasma assisted pre-treatment is a plasma assisted etching. Advantageously, the plasma assisted etching is performed in the reaction chamber upon reaching the predetermined pressure and prior to supplying the gas to the reaction chamber.

Advantageously, the plasma assisted etching comprises supplying an etching gas to, i.e. introducing an etching gas to or passing it through, the reaction chamber, thereby providing the etching gas in the internal volume of the barrel.

Advantageously, the etching gas comprises or substantially consists of one or more of argon, helium, nitrogen, oxygen, methane, ethylene, hydrogen, tetrafluoromethane, nitrogen dioxide or nitrous oxide.

Next, a second electric field is applied to the barrel, so as to use the electrode as an anode and the barrel as a cathode. The second electric field advantageously activates the etching gas, thereby obtaining an etching plasma. The ions of the etching plasma advantageously break down organic contaminants at the surface of the internal surface of the barrel, resulting in volatile components which are removed by the etching gas. The ions of the etching plasma also advantageously attach to the surface of the internal surface, thereby providing the surface of the internal surface with functional groups.

Once the pre-treatment is completed, the second electric field is advantageously turned off and the passage of the etching gas is stopped, i.e. by stopping the supply thereof to the reaction chamber.

Advantages of the methods of the present disclosure include, without being limited thereto, that capability to control the thickness of the deposited coatings, as well as the fact that the coatings are uniform in thickness and homogeneously deposited over the entire surface. A further advantage is that the methods are particularly suited for depositing a coating on long hollow elements, such as barrels, having lengths up to 100 cm, and having a narrow internal diameter, i.e. an internal diameter between 4 mm and 40 mm.

Yet a further advantage is that the methods of the invention allow to obtain coatings having excellent adhesion, and having specific characteristics, thereby improving the lifetime of the barrel. Such characteristics include, without being limited thereto:
- low friction,
- excellent hardness,
- resistance against high mechanical stress such as ammunition peak pressures of about 450 MPa, and
- resistance against thermal stress such as temperatures up to and above 1500 °C (which is considered to be the maximal flame temperature of propulsive powder),
- resistance against chemical stress such as against high temperature corrosive gases and their ions emitted during the combustion of propellant. Such gases are for example CO₂, CO, H₂O, H₂ and N₂. Such ions include H⁺, OH⁻ and NO⁺.

### Brief description of the figures

Aspects of the invention will now be described in more detail with reference to the appended drawings, wherein same reference numerals illustrate same features and wherein:
Figure 1 schematically represents a method according to the invention.
Figure 2 schematically represents a plasma assisted pre-treatment according to the invention.
Figure 3 schematically represents a barrel with a cylindrical electrode arranged within the barrel's internal volume.
Figure 4 schematically represents a barrel with another cylindrical electrode arranged within the barrel's internal volume.
Figure 5 schematically represents a barrel with yet another cylindrical electrode arranged within the barrel's internal volume.
Figure 6 shows a portion of a cross-section of a barrel treated by a method according to the present invention.

### Description of embodiments

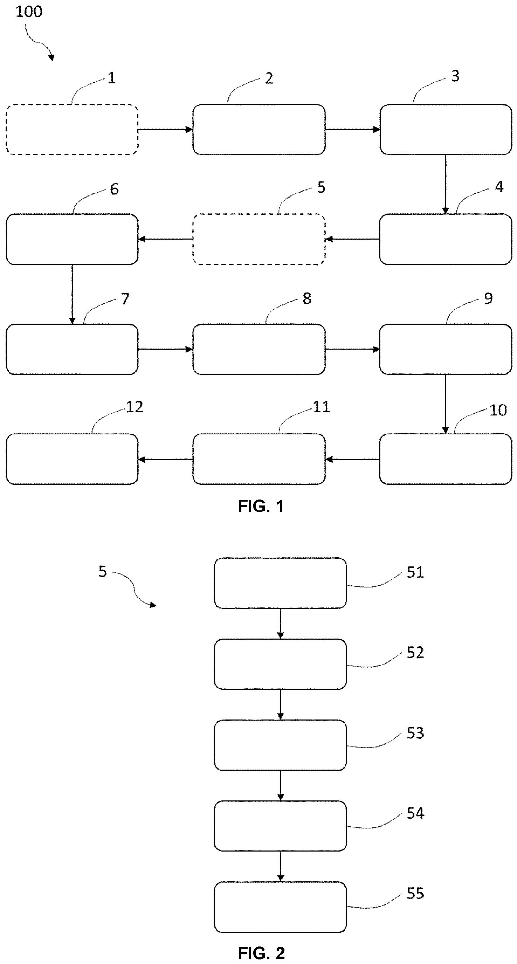

Fig. 1 shows a flowchart of a method 100 for coating the internal surface of a barrel of a small calibre or medium calibre firearm. Such barrels have typically a length between 10 cm and 200 cm, such as between 20 cm and 100 cm. The barrel advantageously has an internal diameter between 5 mm and 20 mm.

The method 100 comprises the steps of:
- optionally pre-treating 1 a small calibre or medium calibre firearm comprising a barrel to be treated, in particular pre-treating the internal surface of the barrel,
- providing 2 the small calibre or medium calibre firearm comprising a barrel to be treated in a reaction chamber,
- in the reaction chamber, providing 3 a cylindrical electrode comprising a target material coaxially within the internal volume of the barrel,
- closing the reaction chamber and reducing the pressure 4 within the closed reaction chamber to a predetermined value or base pressure,
- once the pressure within the reaction chamber reaches the predetermined value or base pressure, optionally pre-treating 5 the internal surface of the barrel,
- supplying 6 a gas to the reaction chamber, thereby providing the gas in the internal volume of the barrel and increasing the pressure within the reaction chamber to a working pressure,
- applying 7 a first electric field to the electrode, so as to use the electrode as a target cathode and the barrel as an anode, thereby activating the gas into a plasma gas,
- removing 8 at least a portion of the target material from the target cathode by the plasma gas, and depositing the removed target material on the internal surface of the barrel, thereby obtaining a treated barrel,
- turning off 9 the first electric field,
- stopping 10 the supply of the gas,
- bringing 11 the reaction chamber back to atmospheric pressure to allow opening thereof, and
- removing 12 the small or medium calibre firearm comprising the treated barrel from the reaction chamber.

Advantageously, the deposition process is a physical vapour deposition process (PVD), performed with a specific cathode and the barrel as anode.

Advantageously, the target material of the electrode comprises or substantially consists of a metal or a metal alloy. Non-limiting examples of metals include chromium, titanium, zirconium, tungsten, aluminum, boron, carbon, cobalt, copper, gold, holmium, iron, lanthanum, lithium, magnesium, manganese, molybdenum, nickel, silicon, silver, tin, vanadium, ytterbium, yttrium, and zinc. Preferred examples of metals include chromium, titanium, zirconium and tungsten. More preferably, the metal is chromium. Non-limiting examples of metal alloys include chromium based alloys, such as NiCr, titanium based alloys, and alloys of refractory metals, such as tungsten based alloys and zirconium based alloys.

Alternatively or additionally, and advantageously, the target material comprises or substantially consists of a ceramic material. Non-limiting examples of ceramic materials include carbides, oxides and nitrides.

Alternatively or additionally, and advantageously, the target material comprises or substantially consists of a composite. Non-limiting examples of composites include composites having a metallic matrix, and organometallic composites.

Advantageously, the composition of the coating deposited on the internal surface of the barrel is determined by both the target material of the target cathode and the gas used to create the plasma conditions.

Advantageously, when the gas comprises or substantially consists of an inert gas, the coating comprises or substantially consists of the target material. Preferred examples of inert gases include argon and helium.

Advantageously, when the gas comprises or substantially consists of a reactive gas, the coating comprises the target material as well as functional groups obtained from the reactive gas. This allows to obtain coatings with a very specific composition, such as ceramic coatings. Non-limiting examples of reactive gases include nitrogen, oxygen, ammonia, fluorocarbons, hydrocarbons. Preferred examples, without being limited thereto, of hydrocarbons are methane and acetylene. Preferred examples, without being limited thereto, of fluorocarbons include C₁-C₄ fluoroalkanes, such as C₁-C₄ perfluoroalkanes, or C₁-C₄ fluoroalkenes, such as C₁-C₄ perfluoroalkenes. Non-limiting examples of suitable fluorocarbons include CF₄, C₂F₆, C₃F₆, C₃F₈, and C₄F₈.

For example, when the reactive gas comprises or substantially consists of nitrogen, the coating advantageously comprises nitrides of the target material. For example, when the reactive gas comprises or substantially consists of hydrocarbons, such as methane and acetylene, the coating advantageously comprises carbides of the target material. For example, when the reactive gas comprises or substantially consists of oxygen, the coating advantageously comprises oxides of the target material.

By means of the methods of the invention, a multilayer coating can be obtained be repeating the process steps. Alternatively and advantageously, a layer of another composition can be obtained by changing one or more process parameters during the deposition step. Advantageously, the gas, the average power density and/or the average current is (are) varied.

For example, a first layer comprising oxides of the target material can be obtained by using a gas comprising or substantially consisting of oxygen, followed by a layer of substantially target material only by changing the gas from oxygen to an inert gas. This allows obtaining coatings with a specific composition and structure, thereby obtaining particular properties.

When the barrel is exposed to the plasma, it can be at room temperature or at an elevated temperature. An elevated temperature is advantageously used to change the microstructure of the growing layer or to promote its growth in a particular crystallographic plane. The temperature can be varied during the deposition of the coating. Advantageously, the barrel can be heated or cooled to a predetermined temperature. Advantageously, the barrel, when it is heated or cooled, is heated or cooled by means known in the art. Advantageously, means for controlling the temperature can be provided, such as temperature sensors, which allow automation of the heating or cooling of the barrel.

The barrel acting as anode can be electrically connected to ground. Alternatively, the barrel can be at floating potential, i.e. without any connection to ground. Yet alternatively, a negative potential difference can be applied to the barrel. The latter advantageously contributes to the adhesion of the coating, as well as to its microstructure and its density.

The inventors have surprisingly discovered that the optional pre-treatment 1, i.e. a pre-treatment that is performed prior to placing the barrel (and thus the firearm) in the reaction chamber, allows to provide the internal surface of the barrel with a surface roughness (Ra) between 0.001 mm and 2 mm, preferably between 0.01 mm and 1.5 mm, more preferably between 0.1 mm and 1 mm. It was found that such a surface roughness surprisingly contributes to the adhesion of the target material to the internal surface of the barrel.

The optional pre-treatment 5, i.e. a pre-treatment that is performed in the reaction chamber with the electrode provided at the internal volume and coaxially with the barrel, can be a plasma assisted pre-treatment. Alternatively or additionally, it can comprise supplying a gas to the reaction chamber, thereby passing it through the internal volume of the barrel, without generating a plasma discharge, for example to remove any moisture.

Fig. 2 shows the steps of one example of the optional pre-treatment 5, wherein the pre-treatment 5 comprises a plasma assisted etching:
- supplying 51 an etching gas to the reaction chamber, thereby providing the etching gas in the internal volume of the barrel,
- applying 52 a second electric field to the barrel so as to use the electrode as an anode and the barrel as a cathode, thereby activating the etching gas into an etching plasma;
- removing 53 the contaminants from the internal surface by the plasma gas,
- turning off 54 the second electric field, and
- stopping 55 the supply of the etching gas.

Advantageously, the average power density applied to the barrel is between 0.01 W/cm² and 50 W/cm², preferably between 0.1 W/cm² and 30 W/cm², more preferably between 0.3 W/cm² and 15 W/cm², such as between 0.5 W/cm² and 10 W/cm², or between 1 W/cm² and 5 W/cm².

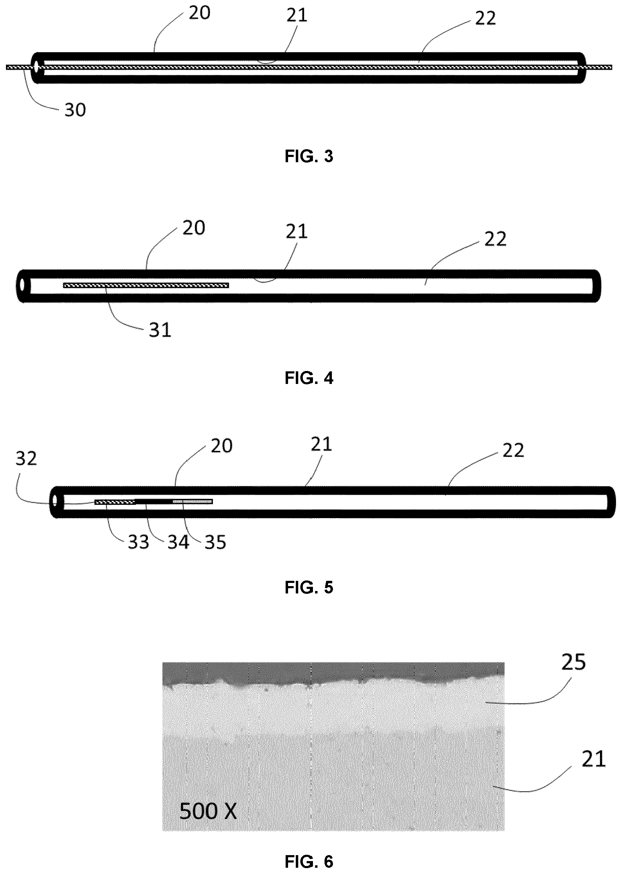

Fig. 3 shows schematically (i.e. not to scale) a first embodiment of carrying out the methods of the present disclosure. A barrel 20 having an internal surface to be treated 21 defining an internal volume 22 is provided. The barrel 20 is a barrel of a small calibre or medium calibre firearm, advantageously having an internal diameter between 4 mm and 40 mm and a length between 10 cm and 200 cm.

An electrode 30, acting as target cathode to which the electric field is applied for igniting a plasma for deposition of the target material thereof on the internal surface 21 of the barrel 20, is provided. The electrode 30 is positioned coaxially with the barrel 20. As shown in Fig. 3, the electrode 30 has a single type of target material evenly distributed over the entire outer surface of the electrode 30.

The electrode 30 has a length which is equal to or higher than the length of the barrel 20. This allows for the electrode 30 to be fixed or attached to a holding means within the reaction chamber for the electrode 30 to stay in place. The cathode 30 allows the generation of the plasma along the entire length of the barrel 20, resulting in the simultaneous coating of the entire internal surface 22 of the barrel 20.

Although a horizontal set-up is shown in Figure 3, the set-up, i.e. the positioning of the barrel 20 and the electrode 30 in the reaction chamber can also be vertical or at any other angle.

Fig. 4 shows schematically (i.e. not to scale) a second embodiment of carrying out the methods of the present disclosure. A barrel 20 having an internal surface to be treated 21 defining an internal volume 22 is provided. The barrel 20 is advantageously as described hereinabove for Fig. 3.

An electrode 31, acting as target cathode to which the electric field is applied for igniting a plasma for deposition of the target material thereof on the internal surface 21 of the barrel 20, is provided. The electrode 31 is positioned coaxially with the barrel 20. As shown in Fig. 4, the electrode 31 has a single type of target material evenly distributed over the entire outer surface of the electrode 31.

The electrode 31 has a length which is lower than the length of the barrel 20. Advantageously, the length of the electrode 31 is at least 5 mm, preferably at least 10 mm, for example at least 20 mm, at least 25 mm, more preferably at least 50 mm, such as at least 75 mm or at least 100 mm.

In order to homogeneously coat the internal surface 21 of the barrel 20, the electrode 31 and the barrel 20 are arranged to be moved relative to one another, while maintaining the coaxial position of the electrode 31 within the barrel 20. Advantageously, the movement is a parallel movement, so as to maintain the coaxial position of the electrode 31 within the barrel 20.

The relative movement can be a movement of the electrode 31 only, of the barrel 20, and of both the electrode 31 and the barrel 20. When the electrode 31 moves, it advantageously moves along the central axis of the barrel 20. When both the electrode 31 and the barrel 20 are moved during the step of deposition of the target material, they can move in the same direction but at a different speed, or in an opposite direction at the same or a different speed.

The second embodiment advantageously allows to create zones with a higher plasma discharge density and zones with a lower plasma discharge density. In particular, the highest plasma density is created at the portion of the internal surface 21 of the barrel 20 located closest to, i.e. at the minimal distance from, the electrode. Similarly, lower plasma density zones are created at portions of the internal surface 21 located further away from the electrode.

Advantageously, the residence time of each portion of the internal surface 21 in the zone with the highest plasma discharge density is between 0.01 s and 300 s, preferably between 0.1 s and 200 s, more preferably between 1 s and 150 s, for example between 2 s and 120 s.

Advantageously, the electrode 31 moves at a speed between 1 mm/min and 10 m/min, for example at a speed between 5 mm/min and 5 m/min, or between 10 mm/min and 1 m/min.

Advantageously, the barrel 20 moves at a speed between 1 mm/min and 10 m/min, for example at a speed between 5 mm/min and 5 m/min, or between 10 mm/min and 1 m/min.

Fig. 5 shows schematically (i.e. not to scale) a second embodiment of carrying out the methods of the present disclosure. A barrel 20 having an internal surface to be treated 21 defining an internal volume 22 is provided. The barrel 20 is advantageously as described hereinabove for Fig. 3.

An electrode 32, acting as target cathode to which the electric field is applied for igniting a plasma for deposition of the target material thereof on the internal surface 21 of the barrel 20, is provided. The electrode 32 is positioned coaxially with the barrel 20, i.e. along the central axis of the barrel 20.

The electrode 32 comprises 3 sub-electrodes 33, 34, 35. Advantageously, each sub-electrode 33, 34, 35 comprises a target material. The target material of at least two of the plurality of sub-electrodes 33, 34, 35 can be the same or can be different. Advantageously, the sub-electrodes 33, 34, 35 are arranged in series.

Advantageously, the sub-electrodes can be sequentially activated and deactivated. Such an arrangement, without being limited thereto, allows to deposit different layers of material onto the internal surface of the barrel.

Although Fig. 5 shows an electrode 32 which has a length lower than the length of the barrel 20, it is to be understood that the electrode 32 can also have a length equal to or higher than the length of the barrel 20. When the electrode 32 has a length equal to or higher than the length of the barrel 20, and a coating is thus deposited without the barrel and the electrode 32 moving relative to one another, the use of sub-electrodes 33, 34, 35 having a different target material allows to deposit a coating having a different (chemical) composition along the length of the barrel 20, i.e. a coating having a (chemical) composition which varies from one location at the internal surface 21 of the barrel 20 to another.

When the electrode 32 and the barrel move relative to one another, the use of a series of sub-electrodes 33, 34, 35 as electrode 32, wherein the target material of every two adjacent sub-electrodes 33, 34, 35 is different, allows the deposition of a multilayer coating. An advantage is that a multi-layer coating can be obtained in a single deposition step instead of having to perform one deposition for each layer of the multilayer coating. Consequently, the process is less complex, and can be performed in a lower total processing time because the reaction chamber does not need to be opened several times to replace the electrode.

### Examples

### Example 1

A carbon steel barrel of 400 mm long and having an internal diameter of 5,56 mm, as part of a small calibre firearm, was sandblasted with abrasive grains having an average grain size between 125 µm and 250 µm. Next, the pre-treated barrel was provided in a reaction chamber.

A cylindrical electrode comprising chromium as target material and having a diameter of 2 mm and a length of 500 mm was provided coaxially within the internal volume of the barrel. The electrode, being slightly longer than the barrel, was fixed to the reaction chamber at both ends, thereby ensuring a stable positioning during the treatment. The distance between the electrode and the internal surface was approximatively 2 mm, more precisely about 1.8 mm.

The reaction chamber was then closed and the pressure was reduced until a predetermined pressure or base pressure of 6.5 mbar was reached. Argon gas was then supplied to, i.e. introduced in or passed through, the chamber, so that the internal volume of the barrel also comprised argon.

An electric field was then applied to the electrode, i.e. the electrode was used as a target cathode, to initiate a plasma discharge. The electric field was a pulsed field, applied at a power of 200 W, a frequency of 250 kHz with a pulse duration (duration of the time that the power was on for each pulse) of 1600 ns.

The product of the working pressure and the distance between the electrode and the internal surface was approximatively 0.97 Torr.cm, more precisely about 0.88 Torr.cm, hence, the argon discharge took place in the Townsend regime.

The argon plasma was then allowed to remove chromium from the target electrode, which then deposited on the internal surface of the barrel, thereby forming a coating.

After 6 hours the electric field was turned off, the flow of argon was stopped, and the chamber was brought back to atmospheric pressure, so that the treated barrel could be removed from the reaction chamber.

To evaluate the coating, a cross-section of the barrel was made, and the cross-section was evaluated by light microscope. Fig. 6 shows the resulting coating 25 on the internal surface 21 of the barrel. The thickness of the coating was 7 µm. It is clear that the coating 25 adheres well to the barrel surface 21, i.e. no gaps are noticed at the interface of the coating 25 and the surface 21. Further, it is also clear that the coating is very uniform in thickness and homogeneous on the internal surface of the barrel. No cracks were noticed, i.e. no defects were visible.

The thermal resistance of the coating was tested by repeated heating to high temperatures followed rapid cooling (quenching). Each heating/rapid cooling cycle had a total duration of 10 minutes. Visual inspection after 1, 2, 5 and 10 heating/rapid cooling cycles showed no cracks or other defects and still a good adhesion to the barrel surface, thereby confirming an excellent thermal resistance.

The hardness was measured by means a Vickers hardness tester using a pyramidal diamond indenter. The applied load was 0.5 N. The coating showed a hardness of about 500 HV (Vickers Hardness).

The canon comprising the treated barrel was also subjected to shooting testing, and showed an excellent performance.

### Example 2

The pre-treated barrel of example 1 was now treated in a reaction chamber, using a target cathode having a length of 70 mm, i.e. lower than the length of the barrel (400 mm).

The processing conditions used were the same as in example 1, except that the electrode was made to move within the internal volume of the barrel, thereby depositing a chromium coating on the entire internal surface of the barrel. The electrode moved at a speed of 10 cm/min.

The obtained coating had properties similar to the coating of example 1 (not shown).

## Claims

1. Method (100) for providing a coating on the internal surface (21) of a barrel (20) of a small calibre or medium calibre firearm, wherein the internal surface (21) of the barrel (20) defines an internal volume (22), the method (100) comprising the steps of:
- providing (2) a small calibre or medium calibre firearm comprising a barrel (20) to be treated in a reaction chamber,
- providing (3), in the reaction chamber, a cylindrical electrode (30, 31, 32) substantially coaxially within the internal volume (22) of the barrel (20), wherein the cylindrical electrode (30, 31, 32) has an outer surface and comprises a target material, and wherein the target material is comprised at least at the outer surface,
- closing the reaction chamber and reducing the pressure (4) within the closed reaction chamber to a predetermined value,
- once the pressure within the reaction chamber reaches the predetermined value, supplying (6) a gas to the reaction chamber, thereby providing the gas in the internal volume (22) of the barrel (20) and increasing the pressure within the reaction chamber to a working pressure,
- applying (7) a first electric field to the electrode (30, 31, 32), so as to use the electrode (30, 31, 32) as a target cathode and the barrel (20) as an anode, thereby activating the gas into a plasma gas;
- removing (8) at least a portion of the target material from the target cathode by the plasma gas, and depositing the removed target material on the internal surface (21) of the barrel (20), thereby obtaining a treated barrel,
- turning off (9) the first electric field,
- stopping (10) the supply of the gas,
- bringing (11) the reaction chamber back to atmospheric pressure to allow opening thereof, and
- removing (12) the small or medium calibre firearm comprising the treated barrel from the reaction chamber,
wherein the distance between the outer surface of the electrode (30, 31, 32) and the internal surface (21) of the barrel is at least 0.5 mm, and the electric field is applied for a duration sufficiently long to form a layer of target material on the internal surface (21) of the barrel, and **characterized in that** the product of the working pressure and the distance between the electrode (30, 31, 32) and the internal surface (21) is between 10⁻⁵ Torr.cm and 45 Torr.cm.

2. Method (100) according to claim 1, wherein the product of the working pressure and the distance between the electrode (30, 31, 32) and the internal surface (21) is between 0.01 Torr.cm and 10 Torr.cm.

3. Method (100) according to any one of the preceding claims, wherein the internal diameter of the barrel (20) is between 4 mm and 40 mm, and the distance between the electrode (30, 31, 32) and the internal surface (21) of the barrel (20) is between 0.5 mm and 19.5 mm.

4. Method (100) according to any one of the preceding claims, wherein the average power density applied to the target cathode is between 0.01 W/cm² and 50 W/cm², and/or the average current density applied to the target cathode is between 0.001 A/cm² and 10 A/cm².

5. Method (100) according to any one of the preceding claims, wherein the target material comprises a metal, a metal alloy, and/or a ceramic material.

6. Method (100) according to claim 5, wherein the target material comprises chromium.

7. Method (100) according to any one of the preceding claims, wherein the gas comprises an inert gas selected from the group consisting of helium, neon, argon, krypton, and/or a reactive gas selected from the group consisting of nitrogen, oxygen, methane, ammonia, acetylene or a fluorocarbon.

8. Method (100) according to any one of the preceding claims, wherein the electrode (30) has a length equal to or higher than the length of the barrel (20), thereby simultaneously depositing the target material over the entire internal surface (21) of the barrel (20).

9. Method (100) according to any one of claims 1 to 7, wherein the electrode (31, 32) has a length lower than the length of the barrel (20), and wherein the electrode (31, 32) and the barrel (20) are configured to move relative to one another, wherein the movement is parallel.

10. Method (100) according to any one of the preceding claims, wherein the electrode (32) comprises a plurality of sub-electrodes (33, 34, 35) arranged in series, wherein each sub-electrode (33, 34, 35) comprises a target material.

11. Method (100) according to claim 12, wherein the target material of at least two of the plurality of sub-electrodes (33, 34, 35) is different.

12. Method (100) according to any one of the preceding claims, further comprising pre-treating the internal surface (21) of the barrel (20) prior to depositing the target material onto the internal surface (21).

13. Method (100) according to claim 12, wherein pre-treating the internal surface (21) of the barrel (20) comprises sandblasting (1) the internal surface (21) prior to providing (2) the small calibre or medium calibre firearm comprising the barrel (20) in the reaction chamber.

14. Method (100) according to any one of claims 12 to 13, wherein pre-treating the internal surface (21) of the barrel (20) comprises a plasma assisted etching (5) of the internal surface (21), wherein the plasma assisted etching is performed in the reaction chamber upon reaching the predetermined pressure and prior to supplying (6) the gas to the reaction chamber, and comprises the steps of:
- supplying (51) an etching gas to the reaction chamber, thereby providing the etching gas in the internal volume (22) of the barrel (20),
- applying (52) a second electric field to the barrel (20) so as to use the electrode (30, 31, 32) as an anode and the barrel (20) as a cathode, thereby activating the etching gas into an etching plasma;
- removing (53) the contaminants from the internal surface (21) by the plasma gas,
- turning off (54) the second electric field, and
- stopping (55) the supply of the etching gas.

15. Method according to claim 14, wherein the etching gas comprises one or more of argon, helium, nitrogen, oxygen, methane, ethylene, tetrafluoromethane, nitrogen dioxide or nitrous oxide.
